(19) **Europäisches Patentamt European Patent Office Office européen des brevets**

(11) **EP 4 343 351 B1**

(12) **EUROPEAN PATENT SPECIFICATION**

(45) Date of publication and mention of the grant of the patent:
**26.11.2025 Bulletin 2025/48**

(21) Application number: **22197558.4**

(22) Date of filing: **23.09.2022**

(51) International Patent Classification (IPC):
***G01R 31/396*** (2019.01)  ***G01R 31/67*** (2020.01)
***G01R 27/20*** (2006.01)

(52) Cooperative Patent Classification (CPC):
**G01R 31/67; G01R 27/205; G01R 31/396**

(54) **IN-SITU MEASUREMENT OF CONTACT RESISTANCE IN A BATTERY MODULE**

IN-SITU-MESSUNG DES KONTAKTWIDERSTANDS IN EINEM BATTERIEMODUL

MESURE IN SITU DE LA RÉSISTANCE DE CONTACT DANS UN MODULE DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.03.2024 Bulletin 2024/13**

(73) Proprietor: **ABB SCHWEIZ AG**
**5400 Baden (CH)**

(72) Inventors:
• **RUEEGG, Walter**
  **5304 Endingen (CH)**
• **Wicki, Stefan**
  **5702 Niederlenz (CH)**
• **ENGELI, Cornel**
  **8005 Zurich (CH)**
• **ZADRA, Luigi**
  **5210 Windisch (CH)**
• **BASLER, Rolf**
  **8288 Schongau (CH)**

(74) Representative: **Sykora & König Patentanwälte PartG mbB**
**Maximilianstraße 2**
**80539 München (DE)**

(56) References cited:
**CN-A- 106 816 905    US-A1- 2016 061 909**
**US-A1- 2022 155 378**

**Description**

FIELD OF THE INVENTION

The invention relates to a method, a computer program and a computer-readable medium for determining a connector resistance. The invention relates also to a cell management unit and a battery module.

BACKGROUND OF THE INVENTION

A battery module with a plurality of cells may comprise a cell management unit, i.e. a control unit, for controlling charge and discharge of the cells and for surveilling the cells. There are cell management units, which can detect an open wire situation, i.e. a disconnect of a contact to a cell pole, but the resistance must be greater than some kOhm in typical cases. A real measurement does not take place. As an alternative, an accurate measurement with an external ohmmeter (best with 4-wire technology) is possible, but not in an assembled (closed) battery module and during operation. A measurement using an ohmmeter is quite time-consuming.

CN 106 816 905 A shows a battery system, with series connected batteries. A balancing unit, including a switch and resistance, and a sample unit are connected in parallel to each battery. From voltages measured during specific opening and closing states of the balancing units, resistances of interconnections between the balancing units and the batteries are calculated.

US 2016/061 909 A1 describes a battery device with series connected batteries. An equalizing switch and a voltage detector are connected in parallel to each battery. A battery monitoring apparatus is adapted to equalize the batteries.

US 2022/155 378 A1 describes a battery resistance diagnosis device.

DESCRIPTION OF THE INVENTION

The determination of the contact resistance or more general the connector resistance is of interest in several cases: A bad contact of an adapter needle (for example due to wear out) during serial tests often generates false negative tests. After assembly of a cell management unit to the cell poles and/or cell connectors, a bad contact of a screw may cause failures, either during commissioning or during operation. During long term operation, a contact corrosion or a loosen screw may cause failures.

It is an objective of the invention to overcome above described problems. Further objectives of the invention are to provide a reliably and easy to maintain battery module.

These objectives are achieved by the subject-matter of the independent claims. Further exemplary embodiments are evident from the dependent claims and the following description.

An aspect of the invention relates to a method for determining a connector resistance of a battery module.

Such a battery module comprises a plurality of cells connected in series. The battery module also comprises a cell management unit with a cell circuit for each of the cells. Each cell circuit comprises a balancing switch and a cell voltage sensor connected in parallel to the respective cell via connectors connected to poles of the respective cell. The cell management unit may be adapted for measuring cell voltages and/or other parameters of the batteries, such as cell temperatures. The cell management unit furthermore may be adapted for controlling balancing between the batteries. Balancing may be done by closing the balancing switches until all batteries have the same cell voltage.

According to an embodiment of the invention, the method comprises: determining a first voltage with the cell voltage sensor of a first cell of the batteries, wherein during the measurement of the first voltage, the balancing switch of the first cell is open and the balancing switch of a second cell neighbouring the first cell is open; determining a second voltage with the cell voltage sensor of the first cell, wherein during the measurement of the second voltage, the balancing switch of the first cell is open and the balancing switch of the second cell is closed; and determining a third voltage with the cell voltage sensor of the second cell, wherein during the measurement of the third voltage, the balancing switch of the first cell is open and the balancing switch of the second cell is closed.

The first cell and the second cell may be neighbouring cells in a strand of series connected cells. The first cell may be connected with the positive pole to the negative pole of the second cell, or vice versa. For the two cells, three different voltages are measured with the cell voltage sensors, which voltages are set by opening and closing the balancing switches of the two cells. The first voltage is measured at the first cell with both balancing switches open. The second voltage is measured at the first cell and the third voltage is measured at the second cell with the first balancing switch open and the second balancing switch closed.

These three voltages are enough for determining a connector resistance of a connector connected between the two cells.

According to an embodiment of the invention, the method comprises: calculating the connector resistance of a connector connected to interconnected poles of the first cell and the second cell, from the first voltage, the second voltage and the third voltage. This calculation may be performed by the cell management unit. A software module or a dedicated hardware component may receive the three voltages and may calculate the connector resistance. The three voltages may be input into a preset formula determined based on the topology and known resistances of the cell circuits, which formula outputs the connector resistance.

With the method, an in-situ measurement of the resistance between a cell electrode (i.e. pole) and the electronic input of the cell management unit may be performed. The connector resistance may be a contact resistance and/or may be the resistance of the interconnection of a pole of a cell with the cell management unit.

The method may be performed during serial tests of the cell management unit, after assembly/commissioning of a battery module or during regular operation using the normal operating system.

No additional hardware is required for performing the method. For the measurement of the voltages and the calculation of the connector resistance, no additional hardware is needed. The regular operating system of the cell management unit with the normal cell voltage measurements via the cell management unit may be used. Only an additional software module is needed.

In the case, when a connector resistance higher than a threshold is calculated, a warning message may be generated, which is sent to a test system or to a superordinated system, such as a car control system, which then may decide to stop operation of the battery module.

The connector resistance may be mainly due to the contact resistance of a screw, for example if the cell management unit is mounted on a module, to the needle of an adapter during serial test of cell management unit or to another contact mean, such as a mechanical contact.

In general, the determination of the connector resistance is performed with a set of measurements of the voltages (via the cell management unit) of the same cell and of an adjacent cell under well-defined conditions (i.e. with and without balancing). Such measurements may be executed in a fraction of a second. The determination of all connector resistances of the battery module may be performed in 1-2 seconds and/or may be executed during start-up of a system including the battery module.

The topology and known resistances of the cell circuits results in a set of linear equations with unknowns. Solving these equations enables the determination of the unknown connector resistance. The solution is a formula, in which the measured voltages are input and which outputs the connector resistance. The error of the measurement of the connector resistance together with some input resistances (for example for filtering and/or protection) is typically of the order of a few ten mOhm for small connector resistances.

The connector resistance may be determined with high accuracy, of the order of 10 mOhm or some 10 mOhm (depending on other resistances). Long term drifts may be detected with an error of a few mOhm.

With the method, false failures during production tests may be minimized, a replacement interval of needle in adapters may be optimized. Furthermore, bad contacts (in particular caused by screws) after assembly of the cell management unit to the batteries may be detected, which results in a lower risk of failures in the field. Furthermore, a method to monitor the integrity of screw terminal contacts may be provided to users, which may be used for preventive maintenance. In general, the battery module has an improved reliability by minimizing the risk of problems with connector and in particular contact resistances, which may be caused during assembly and/or due to long-term issues like losing screws or corrosion.

According to an embodiment of the invention, the connector resistance is calculated by evaluating a formula for the first voltage, the second voltage and the third voltage, which is determined from resistances and circuit topologies of the cell circuits of the first cell and the second cell. The formula may be encoded in software in the cell management unit or in any unit connected to the cell management unit. Based on Kirchhoff's laws, a set of equations can be determined for each cell circuit and by solving these equations, the formula can be determined. The formula depends on the first voltage, the second voltage and the third voltage and from parameters, which parameters depend on known and/or estimated resistances of the cell circuits.

According to an embodiment of the invention, the formula comprises parameters determined from the resistances of the cell circuits of the first cell and the second cell. Such resistances may include a balancing resistor connected in series with the balancing switch and/or resistances of an input circuit which interconnects a cell circuit with its cell.

According to an embodiment of the invention, the formula comprises a balancing resistance as parameter, the balancing resistance representing a resistance of the balancing switch and a balancing resistor connected in series with the balancing switch.

According to an embodiment of the invention, the formula comprises an input circuit resistance as parameter, the input circuit resistance representing a resistance of a circuit between the connector and the balancing switch. Such a circuit may comprise a filter circuit, with for example an inductor, resistor and/or capacitor.

According to an embodiment of the invention, the input circuit resistance represents a resistance of a filter circuit between the connector and the balancing switch.

According to an embodiment of the invention, the connector resistance depends linearly on the factor ($U_{xB+1}$ -

$U_{xm}/U_{(x+1)B}$, wherein $U_{xm}$ is the first voltage, $U_{xB+1}$ is the second voltage and $U_{(x+1)B}$ is the third voltage. The factor may be multiplied with a first parameter, such as the balancing resistance. To the result a second parameter may be subtracted, which may depend on the input circuit resistance.

According to an embodiment of the invention, the connector resistance $R_x$ is calculated by

$$R_x = R_B\,(U_{xB-1} - U_{xm})/U_{(x+1)B} - R$$

wherein $U_{xm}$ is the first voltage, $U_{xB+1}$ is the second voltage, $U_{(x+1)B}$ is the third voltage and $R_B$ and $R$ are parameters determined from circuit topologies of the cell circuits of the first cell and the second cell. For example, $R_B$ is the balancing resistance and/or $R$ may be the resistance of an input circuit and in particular the resistance $R=R_L$ of a filter inductor, which is interconnected between the connector and the balancing switch.

In the cases, when one of the cells does not have a second neighboring, the contact resistance to the pole, which is solely connected to one cell, additionally may be determined with a further voltage measurement.

According to an embodiment of the invention, the second cell is a highest cell in the series connection of cells. This means that the positive pole of the second cell is not connected to the negative pole of a further cell and/or that the positive pole of the second cell is at the highest potential.

According to an embodiment of the invention, the method further comprises: determining a further voltage with the cell voltage sensor of the second cell, wherein during the measurement of the further voltage, the balancing switch of the first cell is open and the balancing switch of the second cell is open; and calculating a highest connector resistance of a highest connector connected to the positive pole of the second cell from the further voltage, the third voltage and the connector resistance calculated from the first, second and third voltage.

The highest connector resistance may be calculated by evaluating a formula for the further voltage, which formula is determined from resistances and circuit topologies of the cell circuits of the first cell and the second cell. The formula may be encoded in software in the cell management unit or in any other unit connected to the cell management unit. The formula depends on the further voltage and from parameters, which parameters depend on known and/or estimated resistances of the cell circuits. For example, the formula comprises parameters determined from the resistances of the cell circuits of the first cell and the second cell. Such resistances may include a balancing resistor connected in series with the balancing switch and/or resistances of an input circuit which interconnects a cell circuit with its cell.

According to an embodiment of the invention, the highest connector resistance $R_{24}$ is calculated by

$$R_{24} = R_B U_{24m}/U_{24B} - R_B - R_{23} - R$$

wherein $U_{24m}$ is the further voltage, $U_{24B}$ is the third voltage, $R_{23}$ is the connector resistance calculated from the first, second and third voltage, and $R_B$ and $R$ are parameters determined from circuit topologies of the cell circuits of the first cell and the second cell.

It has to be noted that here the indices "24" and "23" are chosen, since the battery module shown in the drawing may have 24 cells. However, the battery module may have any number of cells.

For example, $R_B$ is the balancing resistance and/or $R$ may be the resistance of an input circuit and in particular the resistance $R=R_L$ of a filter inductor, which is interconnected between the connector and the balancing switch. The resistance $R = R_{L+}\,R_L$ also may be the sum of a filter inductor resistance $R_L$ and a filter resistor $R_i$.

According to an embodiment of the invention, the first cell is a lowest cell in the series connection of batteries. This means that the negative pole of the first cell is not connected to the positive pole of a further cell and/or that the negative pole of the first cell is at the lowest potential.

According to an embodiment of the invention, the method further comprises: determining a further voltage with the cell voltage sensor of the first cell, wherein during the measurement of the further voltage, the balancing switch of the first cell is closed and the balancing switch of the second cell is open; and calculating a lowest connector resistance of a lowest connector connected to the negative pole of the first cell from the further voltage, the first voltage and the connector resistance calculated from the first, second and third voltage.

The lowest connector resistance may be calculated by evaluating a formula for the further voltage, which formula is determined from resistances and circuit topologies of the cell circuits of the first cell and the second cell. The formula may be encoded in software in the cell management unit or in any other unit connected to the cell management unit. The formula depends on the further voltage and from parameters, which parameters depend on known and/or estimated resistances of the cell circuits. For example, the formula comprises parameters determined from the resistances of the cell circuits of the first cell and the second cell. Such resistances may include a balancing resistor connected in series with the balancing switch and/or resistances of an input circuit which interconnects a cell circuit with its cell.

According to an embodiment of the invention, the lowest connector resistance $R_0$ is calculated by

$$R_0 = R_B U_{1m}/U_{1B} - R_B - R_1 - R$$

wherein $U_{1B}$ is the further voltage, $U_{1m}$ is the first voltage, $R_1$ is the connector resistance calculated from the first, second and third voltage, and $R_B$ and R are parameters determined from circuit topologies of the cell circuits of the first cell and the second cell.

For example, $R_B$ is the balancing resistance and/or R may be the resistance of an input circuit and in particular the resistance $R = R_L$ of a filter resistor $R_i$, which is interconnected into the current path between the connector and the balancing switch.

It has to be understood that for a battery module with more than two cells, the method may be performed several times for each pair of neighbouring cells. With the determination of the highest and lowest connector resistance, all connector resistances of a strand of series connected cells can be determined.

Further aspects of the invention relate to a computer program for determining a connector resistance of a battery module, which, when being executed by a processor, is adapted to carry out the steps of the method as described herein, and to a computer-readable medium, in which such a computer program is stored. A computer-readable medium may be a hard disk, an USB (Universal Serial Bus) storage device, a RAM (Random Access Memory), a ROM (Read Only Memory), an EPROM (Erasable Programmable Read Only Memory) or a FLASH memory. A computer-readable medium may also be a data communication network, e.g. the Internet, which allows downloading a program code. In general, the computer-readable medium may be a non-transitory or transitory medium.

For example, the cell management unit may comprise a processor and a memory, in which the computer program is stored. The method may be implemented as a software module run in the cell management unit or in any other unit connected to the cell management unit.

A further aspect of the invention relates to a cell management unit of a battery module, wherein the cell management unit comprises a cell circuit for each cell of the battery module, wherein each cell circuit comprises a balancing switch and a cell voltage sensor connected in parallel to the respective cell via connectors connected to poles of the cell, and wherein the cell management unit comprises and/or is a controller adapted for performing the method as described herein. It has to be noted that the method may be performed by an additional controller, which may be an additional hardware component of the cell management unit or of any other unit connected to the cell management unit.

A further aspect of the invention relates to a battery module comprising a plurality of cells, which may be connected in series and optionally in parallel, and a cell management unit as described herein.

It has to be understood that features of the method, the computer program and the computer-readable medium as described herein may be features of the cell management unit or in any other unit connected to the cell management unit and the battery module as described herein, and vice versa.

These and other aspects of the invention will be apparent from and elucidated with reference to the embodiments described hereinafter.

BRIEF DESCRIPTION OF THE DRAWINGS

The subject-matter of the invention will be explained in more detail in the following text with reference to exemplary embodiments which are illustrated in the attached drawings.

Fig. 1 schematically shows a battery module according to an embodiment of the invention.
Fig. 2 shows a circuit diagram of the battery module of Fig. 1.
Fig. 3 shows a flow diagram for a method for determining connector resistances of the battery module of Fig. 1.
Fig. 4 shows a flow diagram for a further method for determining connector resistances of the battery module of Fig. 1.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

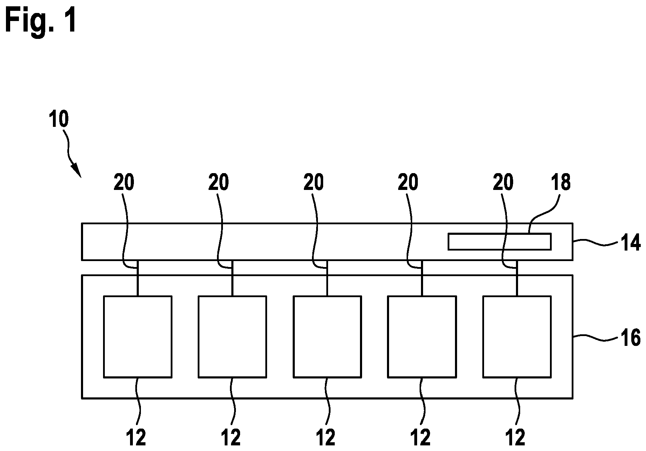

Fig. 1 shows a battery module 10 with a plurality of cells 12 and a cell management unit 14. The batteries 12, such as Li cells, may be assembled together into a housing 16 and the a cell management unit 14 may be mounted to the housing 16. In the following, a battery module 10 with 24 series-connected cells 12 is described. However, the following description also may be applied to a battery module 10 with another number of cells 12 and/or with two or more strands of series-connected batteries 12, which strands may be connected in parallel.

The cell management unit 14 comprises an electronic circuit, which is adapted for the measurement of cell voltages, of temperatures and control of balancing of the batteries 12. The cell management unit 14 comprises a controller 18 with a processor and memory with software, which, when executed, performs these tasks.

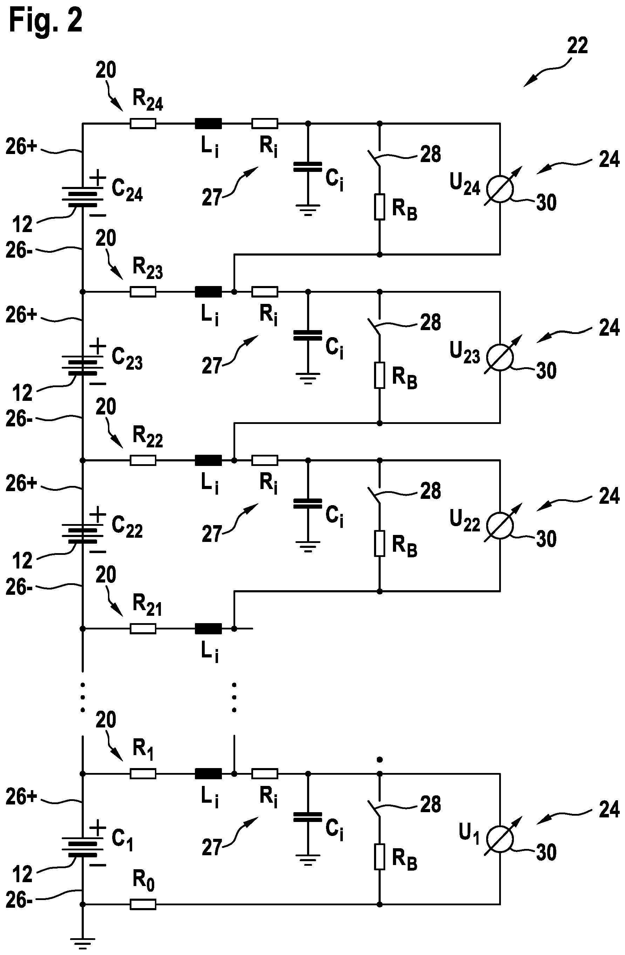

Also, the cell management unit 14 comprises further hardware, such as the circuit 22 described with respect to Fig. 2, which circuit 22 is connected via connectors 20 with poles of the batteries 12. Each connector may comprise a screw, a nut, electric conducting tracks on a circuit board, etc.

Fig. 2 shows a circuit 22 of the cell management unit 14, which is used for measuring voltages, which is composed of a plurality of cell circuits 24, one for each cell 12 of the battery module 10.

The cells 12, which are numbered from $C_1$ to $C_{24}$, are connected in series. A positive pole 26+ is connected to a negative pole 26- of the next cell 12. The resistances of the connectors 20, which are connected to the negative pole 26- to the first cell 12, $B_1$ and to the positive poles 26+ of all batteries 12, are numbered from $R_0$ to $R_{24}$.

An input circuit 27 is via the respective connector 20 connected to the positive pole 26+ of each cell 12. The input circuit 27, which is a filter circuit, comprises a filter inductor $L_i$ connected to the connector 20, a filter resistor $R_i$ connected in series with the filter inductor $L_i$ and a filter capacitor $C_i$, via which grounds a connection of the input circuit 27 and in particular the filter resistor $R_i$ with a balancing switch 28.

Each cell circuit 24 comprises a balancing switch 28 and a cell voltage sensor 30 connected in parallel to the respective cell 12 via the input circuits 27 and the connectors 20. The balancing switches 28, which may be semiconductor switches, such as MOSFETs, are controlled by the cell management unit 14.

For a specific cell 12, a specific balancing switch 28 is connected with one end to the filter resistor $R_i$ of the input circuit 27 of the cell circuit 24 of the specific cell 12 and to which the balancing switch 28 belongs. With another end, the specific balancing switch 28 is connected via a balancing resistor $R_B$ to the input circuit 27 of the cell circuit 24 of the cell 12, which is connected with its negative pole 26- to the specific cell 12. In particular, the balancing switch 28 is connected between the filter inductor $L_i$ connected to and the filter resistor $R_L$ of the input circuit 27 of the previous cell circuit 24.

For the first cell 12, $C_1$, the balancing switch 28 is directly connected via the balancing resistor $R_B$ to the negative pole 26- of the first cell 12, $C_1$.

The cell voltage sensor 30 for measuring the cell voltage of the specific cell 12 is connected in parallel to the specific balancing switch 28 and balancing resistor $R_B$.

Each cell 12 is balanced with its balancing switch 28. For this, the cell management unit 14 measures the cell voltages $U_1$ to $U_{24}$ with the respective cell voltage sensor 30 and closes the balancing switch 28 until the cell voltages of all cells 12 are the same.

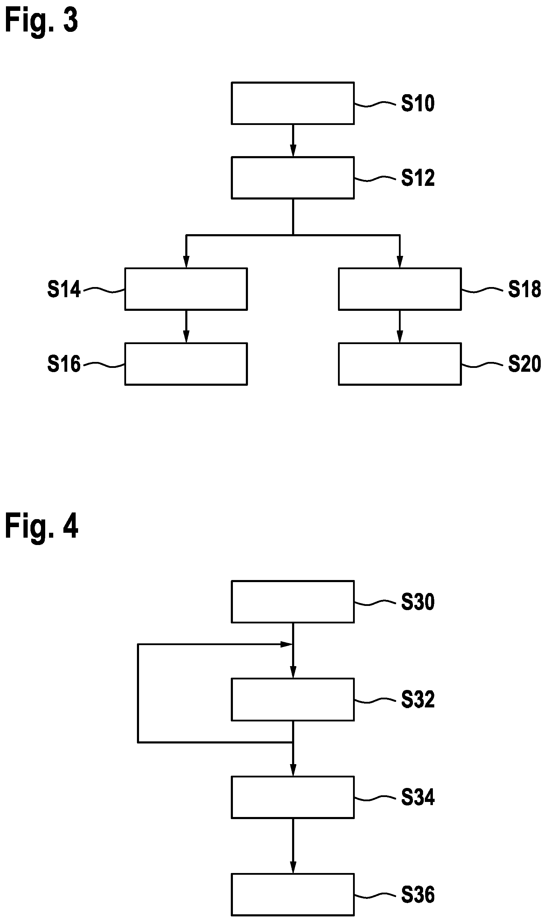

With respect to Fig. 3, a method for determining the connector resistances $R_0$ to $R_{24}$ of the battery module 10 is described. The method is performed automatically by the cell management unit 14 or by any other unit connected to the cell management unit. For example, the normal operating system of the cell management unit 14 may be used for such a determination, which may have an additional software block for this. But it is also possible to connect a small external test device to the cell management unit 14, which may be seen as a temporary part of the cell management unit 14 to perform this task. In this case, there is no need to add an additional software block to the normal operating system. It is also possible to execute the method in any other control system connected to the cell management system.

In steps S10 and S 12, it is assumed that x is a number between 1 and 23, representing one of the connector resistances $R_1$ to $R_{23}$, i.e. $R_x$.

In step S10, a first voltage $U_{xm}$, a second voltage $U_{xB+1}$ and a third voltage $U_{(x+1)B}$ is determined by measurements of the voltage sensors 30 belonging to the batteries 12, $C_x$, which will be called the "first" cell in the following, and of the cell 12, $C_{x+1}$, which will be called the "second" cell.

In particular, the first voltage $U_{xm}$ is determined with the cell voltage sensor 30 of the first cell 12, $C_x$, wherein during the measurement of the first voltage $U_{xm}$, the balancing switch 28 of the first cell 12, $C_x$ is open and the balancing switch 28 of the second cell 12, $C_{x+1}$ neighbouring the first cell 12, $C_x$ is open.

The second voltage $U_{xB+1}$ is determined with the cell voltage sensor 30 of the first cell 12, $C_x$, wherein during the measurement of the second voltage, the balancing switch 28 of the first cell 12, $C_x$ is open and the balancing switch 28 of the second cell 12, $C_{x+1}$ is closed.

The third voltage $U_{(x+1)B}$ is determined with the cell voltage sensor 30 of the second cell 12, $B_{x+1}$, wherein during the measurement of the third voltage, the balancing switch 28 of the first cell 12, $C_x$ is open and the balancing switch 28 of the second cell 12, $C_{x+1}$ is closed.

In step S14, the connector resistance $R_x$ of the connector 20 connected to interconnected poles 26+, 26- of the first cell 12, $C_x$ and the second cell 12, $C_{x+1}$ is determined from the first voltage $U_{xm}$, the second voltage $U_{xB+1}$ and the third voltage $U_{(x+1)B}$.

With the set of three measurements of the cell voltages $U_{xm}$, $U_{xB+1}$ and $U_{(x+1)B}$ of two adjacent batteries 12 under well defined, but different conditions (with and without balancing), a set of linear equations can be created. Solving these equations results in the determination of the connector resistance $R_x$.

Based on Kirchhoff's laws and Ohm's laws, the following equations can be determined

$$R_x = (U_{xB+1} - U_{xm})/I_{x-1} - R_L \qquad (1)$$

$$I_{x+1} = U_{(x+1)B}/R_B \tag{2}$$

In these formulas, $I_{x+1}$ is the current through $R_B$ of the cell circuit 24 of the cell $C_{x+1}$ during balancing. $R_B$ is the resistance of the balancing resistor plus the on-resistance of the balancing switch 28. For example, a typical value for $R_B$ is 20.05 Ohm. $R_L$ is the DC-resistance of the inductor/bead $L_i$ together with the connected PCB-traces. A typical value for $R_L$ is 55 mOhm.

From (1) and (2), a formula for $R_x$ can be derived:

$$R_x = R_B (U_{xB+1} - U_{xm})/U_{(x+1)B} - R_L \tag{3}$$

The connector resistance $R_x$ then can be calculated by evaluating this formula, which depends on the first voltage $U_{xm}$, the second voltage $U_{xB+1}$ and the third voltage $U_{(x+1)B}$ and contains parameters $R_B$ and $R_L$ depending on the circuit topology of the cell circuits 24 of the first cell 12, $C_x$ and the second cell 12, $C_{x+1}$. Note that the connector resistance $R_x$ depends linearly on $(U_{xB+1} - U_{xm})/U_{(x+1)B}$.

In the cases, when the first cell is the cell $C_0$ or the second cell is the cell $C_{24}$, it is also possible to determine the connector resistance $R_0$ and R24 with a further cell voltage measurement.

When the second cell 12, $C_{24}$ is a highest cell in the series connection of batteries, the connector resistance $R_{24}$ can be determined as follows. Note that x=24 is the number of batteries 12 in the series connection and for other embodiments with another number of batteries can be chosen differently.

In step S14, a further voltage $U_{24m}$ is determined with the cell voltage sensor 30 of the second cell 12, $C_{24}$, wherein during the measurement of the further voltage $U_{24m}$, the balancing switch 28 of the first cell 12, $C_{24}$ is open and the balancing switch of the second cell 12, $C_{23}$ is open.

In step S16, the connector resistance $R_{24}$ of the highest connector 20 connected to the positive pole 26+ of the second cell 12, $C_{24}$ is calculated from the further voltage $U_{24m}$, the third voltage $U_{24B}$ and the connector resistance $R_{23}$ calculated from the first voltage $U_{xm}$, the second voltage $U_{xB+1}$ and the third voltage $U_{x+1B}$ with x=23.

In particular, based on Kirchhoff's laws and Ohm's laws, the following equations can be determined:

$$U_{24} = (R_{24} + R_L)(I_s + I_{24}) + I_{24}(R_i + R_B + R_{23} + R_L) \text{ with balancing of } C_{24} \tag{4}$$

$$U_{24} = (R_{24} + R_L)I_s + U_{24m} \qquad\qquad \text{without balancing of } C_{24} \tag{5}$$

$$I_{24} = U_{24B}/R_B \qquad\qquad \text{with balancing of } C_{24} \tag{6}$$

$I_s$ is the supply current drawn by the voltage sensor 30, which typically may be between 5-20 mA. $I_{24}$ is the balancing current of through $R_B$. $R_i$ is the resistance of the corresponding filter resistor, which may be typically 1 Ohm. Again, $R_L$ is the DC-resistance of the inductor/bead $L_i$ together with the connected PCB-traces. $R_{23}$ is the connector resistance determined in steps S10 and S12 with x=23.

Solving (4), (5) and (6) results in

$$R_{24} = R_B U_{24m}/U_{24B} - R_i - R_B - R_{23} - R_L \tag{7}$$

The supply current $I_s$ does not appear in the formula (7), but this is only correct, if $I_s$ does not change during measurement of $U_{24m}$ and $U_{24B}$. $I_s$ may depend on the activity of the cell management unit 14 and variations of some mA are possible.

When the first cell 12, $C_1$ is the lowest cell in the series connection of batteries, the connector resistance $R_0$ can be determined in the following way:

In step S18, a (second) further voltage $U_{1B}$ is determined with the cell voltage sensor 30 of the first cell 12, $C_1$, wherein during the measurement of the further voltage, the balancing switch 28 of the first cell 12, $C_1$ is closed and the balancing switch 28 of the second cell 12, $C_2$ is open.

In step S20, the connector resistance $R_0$ of the lowest connector 20 connected to the negative pole 26- of the first cell 12, $C_1$, is calculated from the further voltage $U_{1B}$, the first voltage $U_m$ and the connector resistance $R_1$ calculated from the first voltage $U_{xm}$, the second voltage $U_{xB+1}$ and the third voltage $U_{x+1B}$ with x=1.

In particular, based on Kirchhoff's laws and Ohm's laws, the following equations can be determined:

$$U_1 = R_1I_1 + R_iI_1 + R_BI_1 + R_0(I_1+I_S) \quad \text{with balancing of } C_1 \qquad (8)$$

$$I_1 = U_{1B}/R_B \qquad \text{with balancing of } C_1 \qquad (9)$$

$$U_1 = U_{1m} + R_oI_s \qquad \text{without balancing of } C_1 \qquad (10)$$

$I_1$ is the balancing current of cell $C_1$ through $R_B$. $I_s$ is again the supply current drawn by the voltage sensor 30.

Solving (8), (9) and (10) results in

$$R_0 = R_BU_{1m}/U_{1B} - R_1 - R_i - R_B \qquad (12)$$

The formulas are only valid, if the cell voltage does not change during the procedure. Such a change may happen during operation, due to changing current through the batteries 12 and may be minimized by performing all measurements within a short time period, such as less than 2 seconds.

A method for determining all connector resistances $R_x$, x=0...24, may be as follows:

In step S30, a measurement of all cell voltages $U_{mx}$, x=1...24 is performed by the cell management unit 14 with no cell balancing, i.e. all balancing switches 28 open.

Step S32 is repeated for all cells $C_x$, x=1...24:

The balancing switch 28 of cell $C_{x+1}$ is closed and the cell voltage of cell $C_x$, i.e. $U_{xB+1}$ and cell $C_{x+1}$, i.e. $U_{(x+1)B}$, are measured with the corresponding cell voltage sensor 30. The connector resistance $R_x$ is then determined with formula (3).

In the end of step S32, the balancing of cell $C_{x+1}$ is switched off, i.e. the balancing switch 28 of cell $C_{x+1}$ is opened again.

In step S34, the balancing switch 28 of cell $C_{24}$ is closed and the cell voltage $U_{24B}$ of cell $C_{24}$ is measured. This also may be done during step S32 with x=23. The connector resistance $R_{24}$ is then determined with formula (7) and the balancing switch 28 of cell $C_{24}$ is opened.

In step S36, the balancing switch 28 of cell $C_1$ is closed and the cell voltage $U_{1B}$ of cell $C_1$ is measured. This also may be done during step S32 with x=1. The connector resistance $R_1$ is then determined with formula (12) and the balancing switch 28 of cell $C_1$ is opened again.

If a connector resistance $R_x$ is smaller than 0, an error message may be generated by the cell management unit 14. This may be caused by no balancing current of cell $C_{x+1}$.

If a connector resistance $R_x$, x=0...24, is higher than a threshold, then the cell management unit 14 or any other unit connected to the cell management unit may generate a warning or error message, which may be sent to a superordinate controller.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

| 10 | battery module |
|----|----------------|
| 12 | cell |
| 14 | cell management unit |
| 16 | housing |
| 18 | controller |
| 20 | connector |
| 22 | circuit |
| 24 | cell circuit |
| 26+ | positive pole |

| 26- | negative pole |
|---|---|
| 27 | input / filter circuit |
| $L_i$ | filter inductor |
| $R_L$ | filter resistor |
| $C_i$ | filter capacitor |
| 28 | balancing switch |
| 30 | cell voltage sensor |
| $C_x$ | x=1...24, cell |
| $R_x$ | x=0...24, connector resistance |
| $U_x$ | x=1...24, cell voltage |
| $U_{xB+1}$ | measured cell voltage of cell x with cell x+1 balancing |
| $U_{(x+1)B}$ | measured cell voltage of cell x+1 with cell x+1 balancing |
| $U_{xm}$ | measured cell voltage of cell x with no cell balancing |

**Claims**

1. A method for determining a connector resistance ($R_0$ to $R_{24}$) of a battery module (10), wherein the battery module (10) comprises a plurality of cells (12) and a cell management unit (14) with a cell circuit (24) for each of the cells (12), wherein each cell circuit (24) comprises a balancing switch (28) and a cell voltage sensor (30) connected in parallel to the respective cell (12) via connectors (20) connected to poles (26+, 26-) of the cell (12); the method comprising:

   determining a first voltage ($U_{xm}$) with the cell voltage sensor (30) of a first cell (12, $C_x$) of the plurality of cells (12), wherein during the measurement of the first voltage ($U_{xm}$), the balancing switch (28) of the first cell (12, $C_x$) is open and the balancing switch (28) of a second cell (12, $C_{x+1}$) neighbouring the first cell (12, $C_x$) is open;
   determining a second voltage ($U_{xB+1}$) with the cell voltage sensor (30) of the first cell (12, $C_x$), wherein during the measurement of the second voltage, the balancing switch (28) of the first cell (12, $C_x$) is open and the balancing switch (28) of the second cell (12, $C_{x+1}$) is closed;
   determining a third voltage ($U_{(x+1)B}$) with the cell voltage sensor (30) of the second cell (12, $C_{x+1}$), wherein during the measurement of the third voltage, the balancing switch (28) of the first cell (12, $C_x$) is open and the balancing switch (28) of the second cell (12, $C_{x+1}$) is closed;
   calculating the connector resistance ($R_x$) of a connector (20) connected to interconnected poles (26+, 26-) of the first cell (12, $C_x$) and the second cell (12, $C_{x+1}$), from the first voltage ($U_{xm}$), the second voltage ($U_{xB+1}$) and the third voltage ($U_{(x+1)B}$);
   wherein the connector resistance ($R_x$) is calculated by evaluating a formula for the first voltage ($U_{xm}$), the second voltage ($U_{xB+1}$) and the third voltage ($U_{(x+1)B}$), which is determined from resistances ($R_B$, $R_i$) and circuit topologies of the cell circuits (24) of the first cell (12, $C_x$) and the second cell (12, $C_{x+1}$);
   wherein the formula comprises an input circuit resistance ($R_L$) as parameter, the input circuit resistance ($R_L$) representing a resistance of a circuit (27) between the connector (20) and the balancing switch (28).

2. The method of claim 1, wherein the formula comprises parameters determined from the resistances of the cell circuits (24) of the first cell (12, $C_x$) and the second cell (12, $C_{x+1}$).

3. The method of claim 1 or 2, wherein the formula comprises a balancing resistance ($R_B$) as parameter, the balancing resistance ($R_B$) representing a resistance of the balancing switch (28) and a balancing resistor connected in series with the balancing switch (28).

4. The method of one of the previous claims, wherein the input circuit resistance ($R_L$) represents a resistance of a filter circuit (27) between the connector (20) and the balancing switch (28).

5. The method of one of the previous claims, wherein the connector resistance ($R_x$) depends linearly on $(U_{xB+1} - U_{xm})/U_{(x+1)B}$, wherein $U_{xm}$ is the first voltage, $U_{xB+1}$ is the second voltage and $U_{(x+1)B}$ is the third voltage.

6. The method of one of the previous claims,

wherein the connector resistance $R_x$ is calculated by

$$R_x = R_B (U_{xB+1} - U_{xm})/U_{(x+1)B} - R$$

wherein $U_{xm}$ is the first voltage, $U_{xB+1}$ is the second voltage, $U_{(x+1)B}$ is the third voltage and $R_B$ and $R$ are parameters determined from circuit topologies of the cell circuits (24) of the first cell (12, $C_x$) and the second cell.

7. The method of one of the previous claims,
   wherein the first cell (12, $C_x$) is connected via its positive pole (26+) with the negative pole (26-) of the second cell (12, $C_{x+1}$).

8. The method of one of the previous claims,
   wherein the second cell (12, $C_{24}$) is a highest cell in the series connection of cells and the method further comprises:

   determining a further voltage ($U_{24m}$) with the cell voltage sensor (30) of the second cell (12, $C_{24}$), wherein during the measurement of the further voltage ($U_{24m}$), the balancing switch (28) of the first cell (12, $C_{24}$) is open and the balancing switch of the second cell (12, $C_{23}$) is open;
   calculating a connector resistance ($R_{24}$) of a highest connector (20) connected to the positive pole (26+) of the second cell (12, $C_{24}$) from the further voltage ($U_{24m}$), the third voltage ($U_{24B}$) and the connector resistance ($R_{23}$) calculated from the first voltage ($U_{xm}$), the second voltage ($U_{xB+1}$) and the third voltage ($U_{(x+1)B}$).

9. The method of claim 8,

   wherein the highest connector resistance $R_{24}$ is calculated by

   $$R_{24} = R_B U_{24m}/U_{24B} - R_B - R_{23} - R$$

   wherein $U_{24m}$ is the further voltage, $U_{24B}$ is the third voltage, $R_{23}$ is the connector resistance calculated from the first, second and third voltage, and $R_B$ and $R$ are parameters determined from circuit topologies of the cell circuits (24) of the first cell (12, $C_{23}$) and the second cell (12, $C_{24}$).

10. The method of one of the previous claims,
    wherein the first cell (12, $C_1$) is a lowest cell in the series connection of cells and the method further comprises:

    determining a further voltage ($U_{1B}$) with the cell voltage sensor (30) of the first cell (12, $C_1$), wherein during the measurement of the further voltage, the balancing switch (28) of the first cell (12, $C_1$) is closed and the balancing switch (28) of the second cell (12, $C_2$) is open;
    calculating the connector resistance ($R_0$) of a lowest connector (20) connected to the negative pole (26-) of the first cell (12, $C_1$) from the further voltage ($U_{1B}$), the first voltage ($U_{1m}$) and the connector resistance ($R_1$) calculated from the first voltage ($U_{xm}$), the second voltage ($U_{xB+1}$) and the third voltage ($U_{(x+1)B}$).

11. The method of claim 10,

    wherein the lowest connector resistance $R_0$ is calculated by

    $$R_0 = R_B U_{1m}/U_{1B} - R_B - R_1 - R$$

    wherein $U_{1B}$ is the further voltage, $U_{1m}$ is the first voltage, $R_1$ is the connector resistance calculated from the first, second and third voltage, and $R_B$ and $R$ are parameters determined from circuit topologies of the cell circuits (24) of the first cell and the second cell.

12. A computer program for determining a connector resistance ($R_0$ to $R_{24}$) of a battery module (10), which, when being executed by a processor, is adapted to carry out the steps of the method of one of the previous claims.

13. A computer-readable medium, in which a computer program according to claim 12 is stored.

14. A cell management unit (14) of a battery module (10),

wherein the cell management unit (14) comprises a cell circuit (24) for each cell (12) of the battery module (10);
wherein each cell circuit (24) comprises a balancing switch (28) and a cell voltage sensor (30) connected in parallel to the respective cell (12) via connectors (20) connected to poles (26+, 26-) of the cell (12);
wherein the cell management unit (14) comprises a controller (18) adapted for performing the method of one of claims 1 to 11.

15. A battery module (10), comprising:

a plurality of cells (12),
a cell management unit (14) according to claim 14.

**Patentansprüche**

1. Verfahren zum Bestimmen eines Verbinderwiderstands ($R_0$ bis $R_{24}$) eines Batteriemoduls (10), wobei das Batteriemodul (10) mehrere Zellen (12) und eine Zellenverwaltungseinheit (14) mit einer Zellenschaltung (24) für jede der Zellen (12) umfasst, wobei jede Zellenschaltung (24) einen Ausgleichsschalter (28) und einen Zellenspannungssensor (30) in Parallelschaltung mit der jeweiligen Zelle (12) über mit Polen (26+, 26-) der Zelle (12) verbundene Verbinder (20) umfasst;
wobei das Verfahren Folgendes umfasst:

Bestimmen einer ersten Spannung ($U_{xm}$) mit dem Zellenspannungssensor (30) einer ersten Zelle (12, $C_x$) der mehreren Zellen (12),
wobei während des Messens der ersten Spannung ($U_{xm}$) der Ausgleichsschalter (28) der ersten Zelle (12, $C_x$) offen ist und der Ausgleichsschalter (28) einer zweiten Zelle (12, $C_{x+1}$), die der ersten Zelle (12, $C_x$) benachbart ist, offen ist;
Bestimmen einer zweiten Spannung ($U_{XB+1}$) mit dem Zellenspannungssensor (30) der ersten Zelle (12, $C_x$), wobei während der Messung der zweiten Spannung der Ausgleichsschalter (28) der ersten Zelle (12, $C_x$) offen ist und der Ausgleichsschalter (28) der zweiten Zelle (12, $C_{x+1}$) geschlossen ist;
Bestimmen einer dritten Spannung ($U_{(x+1)B}$) mit dem Zellenspannungssensor (30) der zweiten Zelle (12, $C_{x+1}$), wobei während der Messung der dritten Spannung der Ausgleichsschalter (28) der ersten Zelle (12, $C_x$) offen ist und der Ausgleichsschalter (28) der zweiten Zelle (12, $C_{x+1}$) geschlossen ist;
Berechnen des Verbinderwiderstands ($R_x$) eines mit miteinander verbundenen Polen (26+, 26-) der ersten Zelle (12, $C_x$) und der zweiten Zelle (12, $C_{x+1}$) verbundenen Verbinders (20) aus der ersten Spannung ($U_{xm}$), der zweiten Spannung ($U_{xB+1}$) und der dritten Spannung ($U_{(x+1)B}$);
wobei der Verbinderwiderstand ($R_x$) durch Auswerten einer Formel für die erste Spannung ($U_{xm}$), die zweite Spannung ($U_{xB+1}$) und die dritte Spannung ($U_{(x+1)B}$) berechnet wird, die aus Widerständen ($R_B$, $R_i$) und Schaltungstopologien der Zellenschaltungen (24) der ersten Zelle (12, $C_x$) und der zweiten Zelle (12, $C_{x+1}$) bestimmt wird;
wobei die Formel einen Eingangsschaltungswiderstand ($R_L$) als Parameter umfasst, wobei der Eingangsschaltungswiderstand ($R_L$) einen Widerstand einer Schaltung (27) zwischen dem Verbinder (20) und dem Ausgleichsschalter (28) repräsentiert.

2. Verfahren nach Anspruch 1,
wobei die Formel Parameter umfasst, die aus den Widerständen der Zellenschaltungen (24) der ersten Zelle (12, $C_x$) und der zweiten Zelle (12, $C_{x+1}$) bestimmt werden.

3. Verfahren nach Anspruch 1 oder 2,
wobei die Formel einen Ausgleichswiderstand ($R_B$) als Parameter umfasst, wobei der Ausgleichswiderstand ($R_B$) einen Widerstand des Ausgleichsschalters (28) und eines mit dem Ausgleichsschalter (28) in Reihe geschalteten Ausgleichswiderstands repräsentiert.

4. Verfahren nach einem der vorherigen Ansprüche,
wobei der Eingangsschaltungswiderstand ($R_L$) einen Widerstand einer Filterschaltung (27) zwischen dem Verbinder (20) und dem Ausgleichsschalter (28) repräsentiert.

5. Verfahren nach einem der vorherigen Ansprüche,
wobei der Verbinderwiderstand ($R_x$) linear von $(U_{xB+1}-U_{xm})/U_{(x+1)B}$ abhängt, wobei $U_{xm}$ die erste Spannung ist, $U_{xB+1}$

die zweite Spannung ist und $U_{(x+1)B}$ die dritte Spannung ist.

6. Verfahren nach einem der vorherigen Ansprüche, wobei der Verbinderwiderstand $R_x$ berechnet wird durch

$$R_x = R_B (U_{xB+1} - U_{xm})/U_{(x+1)B} - R$$

wobei $U_{xm}$ die erste Spannung ist, $U_{XB+1}$ die zweite Spannung ist, $U_{(x+1)B}$ die dritte Spannung ist und $R_B$ und R Parameter sind, die aus Schaltungstopologien der Zellenschaltungen (24) der ersten Zelle (12, $C_x$) und der zweiten Zelle bestimmt werden.

7. Verfahren nach einem der vorherigen Ansprüche, wobei die erste Zelle (12, $C_x$) über ihren positiven Pol (26+) mit dem negativen Pol (26-) der zweiten Zelle (12, $C_{x+1}$) verbunden ist.

8. Verfahren nach einem der vorherigen Ansprüche,
wobei die zweite Zelle (12, $C_{24}$) eine höchste Zelle in der Reihenschaltung von Zellen ist und das Verfahren ferner Folgendes umfasst:

Bestimmen einer weiteren Spannung ($U_{24m}$) mit dem Zellenspannungssensor (30) der zweiten Zelle (12, $C_{24}$), wobei während der Messung der weiteren Spannung ($U_{24m}$) der Ausgleichsschalter (28) der ersten Zelle (12, $C_{24}$) offen ist und der Ausgleichsschalter der zweiten Zelle (12, $C_{23}$) offen ist;
Berechnen eines Verbinderwiderstands ($R_{24}$) eines höchsten Verbinders (20), der mit dem positiven Pol (26+) der zweiten Zelle (12, $C_{24}$) verbunden ist, aus der weiteren Spannung ($U_{24m}$), der dritten Spannung ($U_{24B}$) und dem aus der ersten Spannung ($U_{xm}$), der zweiten Spannung ($U_{xB+1}$) und der dritten Spannung ($U_{(x+1)B}$) berechneten Verbinderwiderstand ($R_{23}$).

9. Verfahren nach Anspruch 8,

wobei der höchste Verbinderwiderstand $R_{24}$ berechnet wird durch

$$R_{24} = R_B U_{24m}/U_{24B} - R_B - R_{23} - R$$

wobei $U_{24m}$ die weitere Spannung ist, $U_{24B}$ die dritte Spannung ist, $R_{23}$ der aus der ersten Spannung, der zweiten Spannung und der dritten Spannung berechnete Verbinderwiderstand ist und $R_B$ und R Parameter sind, die aus Schaltungstopologien der Zellenschaltungen (24) der ersten Zelle (12, $C_{23}$) und der zweiten Zelle (12, $C_{24}$) bestimmt werden.

10. Verfahren nach einem der vorherigen Ansprüche,
wobei die erste Zelle (12, $C_1$) eine niedrigste Zelle in der Reihenschaltung von Zellen ist und das Verfahren ferner Folgendes umfasst:

Bestimmen einer weiteren Spannung ($U_{1B}$) mit dem Zellenspannungssensor (30) der ersten Zelle (12, $C_1$), wobei während der Messung der weiteren Spannung der Ausgleichsschalter (28) der ersten Zelle (12, $C_1$) geschlossen ist und der Ausgleichsschalter (28) der zweiten Zelle (12, $C_2$) offen ist;
Berechnen des Verbinderwiderstands ($R_0$) eines niedrigsten Verbinders (20), der mit dem negativen Pol (26-) der ersten Zelle (12, $C_1$) verbunden ist, aus der weiteren Spannung ($U_{1B}$), der ersten Spannung ($U_{1m}$) und dem aus der ersten Spannung ($U_{xm}$), der zweiten Spannung ($U_{xB+1}$) und der dritten Spannung ($U_{(x+1)B}$) berechneten Verbinderwiderstand ($R_1$).

11. Verfahren nach Anspruch 10,

wobei der niedrigste Verbinderwiderstand $R_0$ berechnet wird durch

$$R_0 = R_B U_{1m}/U_{1B} - R_B - R_1 - R$$

wobei $U_{1B}$ die weitere Spannung ist, $U_{1m}$ die erste Spannung ist, $R_1$ der aus der ersten Spannung, zweiten Spannung und dritten Spannung berechnete Verbinderwiderstand ist und $R_B$ und R Parameter sind, die aus Schaltungstopologien der Zellenschaltungen (24) der ersten Zelle und der zweiten Zelle bestimmt werden.

12. Computerprogramm zum Bestimmen eines Verbinderwiderstands ($R_0$ bis $R_{24}$) eines Batteriemoduls (10), das, wenn es durch einen Prozessor ausgeführt wird, dafür ausgelegt ist, die Schritte des Verfahrens nach einem der vorherigen Ansprüche auszuführen.

13. Computerlesbares Medium, in dem ein Computerprogramm nach Anspruch 12 gespeichert ist.

14. Zellenverwaltungseinheit (14) eines Batteriemoduls (10),

wobei die Zellenverwaltungseinheit (14) für jede Zelle (12) des Batteriemoduls (10) eine Zellenschaltung (24) umfasst;
wobei jede Zellenschaltung (24) einen Ausgleichsschalter (28) und einen Zellenspannungssensor (30) in Parallelschaltung mit der jeweiligen Zelle (12) über mit Polen (26+, 26-) der Zelle (12) verbundene Verbinder (20) umfasst;
wobei die Zellenverwaltungseinheit (14) eine Steuerung (18) umfasst, die dafür ausgelegt ist, das Verfahren nach einem der Ansprüche 1 bis 11 auszuführen.

15. Batteriemodul (10), umfassend:

mehrere Zellen (12),
eine Zellenverwaltungseinheit (14) nach Anspruch 14.

**Revendications**

1. Procédé pour déterminer une résistance de connecteur ($R_0$ à $R_{24}$) d'un module de batterie (10), dans lequel le module de batterie (10) comprend une pluralité de cellules (12) et une unité de gestion de cellules (14) ayant un circuit de cellule (24) pour chacune des cellules (12), dans lequel chaque circuit de cellule (24) comprend un commutateur d'équilibrage (28) et un capteur de tension de cellule (30) connecté en parallèle à la cellule respective (12) via des connecteurs (20) connectés aux pôles (26+, 26-) de la cellule (12) ;
le procédé comprenant :

la détermination d'une première tension ($U_{xm}$) au moyen du capteur de tension de cellule (30) d'une première cellule (12, $C_x$) de la pluralité de cellules (12),
dans lequel, pendant la mesure de la première tension ($U_{xm}$), le commutateur d'équilibrage (28) de la première cellule (12, $C_x$) est ouvert et le commutateur d'équilibrage (28) d'une deuxième cellule (12, $C_{x+1}$) voisine de la première cellule (12, $C_x$) est ouvert ;
la détermination d'une deuxième tension ($U_{xb+1}$) au moyen du capteur de tension de cellule (30) de la première cellule (12, $C_x$), dans lequel, pendant la mesure de la deuxième tension, le commutateur d'équilibrage (28) de la première cellule (12, $C_x$) est ouvert et le commutateur d'équilibrage (28) de la deuxième cellule (12, $C_{x+1}$) est fermé ;
la détermination d'une troisième tension ($U_{(x+1)B}$) au moyen du capteur de tension de cellule (30) de la deuxième cellule (12, $C_{x+1}$), dans lequel, pendant la mesure de la troisième tension, le commutateur d'équilibrage (28) de la première cellule (12, $C_x$) est ouvert et le commutateur d'équilibrage (28) de la deuxième cellule (12, $C_{x+1}$) est fermé ;
le calcul de la résistance de connecteur ($R_x$) d'un connecteur (20) connecté à des pôles interconnectés (26+, 26-) de la première cellule (12, $C_x$) et de la deuxième cellule (12, $C_{x+1}$), à partir de la première tension ($U_{xm}$), de la deuxième tension ($U_{xB+1}$) et de la troisième tension ($U_{(x+1)B}$) ;
dans lequel la résistance de connecteur ($R_x$) est calculée par évaluation d'une formule pour la première tension ($U_{xm}$), la deuxième tension ($U_{xb+1}$) et la troisième tension ($U_{(x+1)B}$), qui est déterminée à partir des résistances ($R_B$, $R_i$) et des topologies de circuit des circuits de cellules (24) de la première cellule (12, $C_x$) et de la deuxième cellule (12, $C_{x+1}$) ;
dans lequel la formule comprend une résistance de circuit d'entrée ($R_I$) en tant que paramètre, la résistance de circuit d'entrée ($R_1$) représentant une résistance d'un circuit (27) entre le connecteur (20) et le commutateur d'équilibrage (28).

2. Procédé selon la revendication 1,

dans lequel la formule comprend des paramètres déterminés à partir des résistances des circuits de cellules (24) de la première cellule (12, $C_x$) et de la deuxième cellule (12, $C_{x+1}$).

3. Procédé selon la revendication 1 ou 2,
dans lequel la formule comprend une résistance d'équilibrage ($R_B$) en tant que paramètre, la résistance d'équilibrage ($R_B$) représentant une résistance du commutateur d'équilibrage (28) et une résistance d'équilibrage connectée en série avec le commutateur d'équilibrage (28).

4. Procédé selon l'une des revendications précédentes, dans lequel la résistance de circuit d'entrée ($R_1$) représente une résistance d'un circuit de filtrage (27) entre le connecteur (20) et le commutateur d'équilibrage (28).

5. Procédé selon l'une des revendications précédentes, dans lequel la résistance de connecteur ($R_x$) dépend linéairement de $(U_{xb+1}-U_{xm})/U_{(x+1)B}$, où $U_{xm}$ est la première tension, $U_{xB+1}$ est la deuxième tension et $U_{(x+1)B}$ est la troisième tension.

6. Procédé selon l'une des revendications précédentes, dans lequel la résistance de connecteur $R_x$ est calculée par

$$R_x = R_B (U_{xB+1} - U_{xm})/U_{(x+1)B} - R$$

où $U_{xm}$ est la première tension, $U_{xb+1}$ est la deuxième tension, $U_{(x+1)B}$ est la troisième tension et $R_B$ et $R$ sont des paramètres déterminés à partir de topologies de circuit des circuits de cellules (24) de la première cellule (12, $C_x$) et de la deuxième cellule.

7. Procédé selon l'une des revendications précédentes, dans lequel la première cellule (12, $C_x$) est connectée par son pôle positif (26+) au pôle négatif (26-) de la deuxième cellule (12, $C_{x+1}$).

8. Procédé selon l'une des revendications précédentes, dans lequel la deuxième cellule (12, $C_{24}$) est une cellule la plus élevée dans la connexion en série de cellules et le procédé comprend en outre :

la détermination d'une autre tension ($U_{24m}$) au moyen du capteur de tension de cellule (30) de la deuxième cellule (12, $C_{24}$), dans lequel, pendant la mesure de l'autre tension ($U_{24m}$), le commutateur d'équilibrage (28) de la première cellule (12, $C_{24}$) est ouvert et le commutateur d'équilibrage de la deuxième cellule (12, $C_{23}$) est ouvert ;
le calcul d'une résistance de connecteur ($R_{24}$) d'un connecteur le plus élevé (20) connecté au pôle positif (26+) de la deuxième cellule (12, $C_{24}$) à partir de l'autre tension ($U_{24m}$), de la troisième tension ($U_{24B}$) et de la résistance de connecteur ($R_{23}$) calculée à partir de la première tension ($U_{xm}$), de la deuxième tension ($U_{XB+1}$) et de la troisième tension ($U_{(x+1)B}$).

9. Procédé selon la revendication 8,

dans lequel la résistance de connecteur la plus élevée $R_{24}$ est calculée par

$$R_{24} = R_B U_{24m}/U_{24B} - R_B - R_{23} - R$$

où $U_{24m}$ est l'autre tension, $U_{24B}$ est la troisième tension, $R_{23}$ est la résistance de connecteur calculée à partir des première, deuxième et troisième tensions, et $R_B$ et $R$ sont des paramètres déterminés à partir des topologies de circuit des circuits de cellules (24) de la première cellule (12, $C_{23}$) et de la deuxième cellule (12, $C_{24}$)

10. Procédé selon l'une des revendications précédentes, dans lequel la première cellule (12, $C_1$) est une cellule la plus basse dans la connexion en série de cellules et le procédé comprend en outre :

la détermination d'une autre tension ($U_{1B}$) au moyen du capteur de tension de cellule (30) de la première cellule (12, $C_1$), dans lequel, pendant la mesure de l'autre tension, le commutateur d'équilibrage (28) de la première cellule (12, $C_1$) est fermé et le commutateur d'équilibrage (28) de la deuxième cellule (12, $C_2$) est ouvert ;
le calcul de la résistance de connecteur ($R_0$) d'un connecteur le plus bas (20) connecté au pôle négatif (26-) de la première cellule (12, $C_1$) à partir de l'autre tension ($U_{1B}$), de la première tension ($U_{1m}$) et de la résistance de connecteur ($R_1$) calculée à partir de la première tension ($U_{xm}$), de la deuxième tension ($U_{XB+1}$) et de la troisième tension ($U_{(x+1)B}$).

**11.** Procédé selon la revendication 10,

dans lequel la résistance de connecteur le plus bas $R_0$ est calculée par

$$R_0 = R_B U_{1m}/U_{1B} - R_B - R_1 - R$$

où $U_{1B}$ est l'autre tension, $U_{1m}$ est la première tension, $R_1$ est la résistance de connecteur calculée à partir des première, deuxième et troisième tensions, et $R_B$ et R sont des paramètres déterminés à partir des topologies de circuit des circuits de cellules (24) de la première cellule et de la deuxième cellule.

**12.** Programme informatique destiné à déterminer une résistance de connecteur ($R_0$ à $R_{24}$) d'un module de batterie (10), qui, lorsqu'il est exécuté par un processeur, est prévu pour réaliser les étapes du procédé selon l'une des revendications précédentes.

**13.** Support lisible par ordinateur, sur lequel est stocké un programme informatique selon la revendication 12.

**14.** Unité de gestion de cellules (14) d'un module de batterie (10),

dans lequel l'unité de gestion de cellules (14) comprend un circuit de cellule (24) pour chaque cellule (12) du module de batterie (10) ;
dans lequel chaque circuit de cellule (24) comprend un commutateur d'équilibrage (28) et un capteur de tension de cellule (30) connecté en parallèle à la cellule respective (12) via des connecteurs (20) connectés aux pôles (26+, 26-) de la cellule (12) ;
dans lequel l'unité de gestion de cellule (14) comprend un dispositif de commande (18) conçu pour mettre en œuvre le procédé selon l'une des revendications 1 à 11.

**15.** Module de batterie (10), comprenant :

une pluralité de cellules (12),
une unité de gestion de cellules (14) selon la revendication 14.

# Fig. 1

## Fig. 2

## Fig. 3

```
┌──────────────┐
│              │──── S10
└──────────────┘
       │
       ▼
┌──────────────┐
│              │──── S12
└──────────────┘
       │
   ┌───┴───────────────────┐
   ▼                       ▼
┌──────────┐          ┌──────────┐
S14 ──│          │          │          │──── S18
└──────────┘          └──────────┘
   │                       │
   ▼                       ▼
┌──────────┐          ┌──────────┐
S16 ──│          │          │          │──── S20
└──────────┘          └──────────┘
```

## Fig. 4

```
       ┌──────────────┐
       │              │──── S30
       └──────────────┘
              │
  ┌──────────▶│
  │           ▼
  │    ┌──────────────┐
  │    │              │──── S32
  │    └──────────────┘
  │           │
  └───────────┤
              ▼
       ┌──────────────┐
       │              │──── S34
       └──────────────┘
              │
              ▼
       ┌──────────────┐
       │              │──── S36
       └──────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 106816905 A
- US 2016061909 A1
- US 2022155378 A1